# EUROPEAN PATENT SPECIFICATION

(11) **EP 2 034 535 B1**
(45) Date of publication and mention of the grant of the patent: **10.02.2016**
(21) Application number: 08015566.6
(22) Date of filing: 03.09.2008
(51) Int. Cl.: H01L 41/187, H01L 41/09, H01L 41/316, B41J 2/14, B41J 2/16

(54) **Piezoelectric device, liquid droplet ejecting head using the same, and process for producing the same**
Piezoelektrische Vorrichtung, Flüssigkeitstropfenausgabekopf damit und Herstellungsverfahren
Dispositif piézoélectrique, tête d'éjection de gouttelettes liquides l'utilisant, et son procédé de production

(30) Priority: 07.09.2007 JP 2007233017
(43) Date of publication of application: 11.03.2009
(73) Proprietor: FUJIFILM Corporation, Minato-ku Tokyo (JP)
(72) Inventor: Naono, Takayuki, Ashigara-kami-gun Kanagawa (JP); Arakawa, Takami, Ashigara-kami-gun Kanagawa (JP); Fujii, Takamichi, Kanagawa (JP)
(74) Representative: Klunker . Schmitt-Nilson . Hirsch

(56) References cited:
- EP-A1- 0 747 976
- EP-A2- 2 031 084
- US-A1- 2005 218 756
- US-B1- 6 333 066
- SHVARTSMAN V ET AL: "Nonlinear local piezoelectric deformation in ferroelectric thin films studied by scanning force microscopy", JOURNAL OF APPLIED PHYSICS, AMERICAN INSTITUTE OF PHYSICS. NEW YORK, US, vol. 97, no. 10, 2 May 2005 (2005-05-02), pages 104105/1-11, XP012069393, ISSN: 0021-8979

## Description

The present invention relates to a process for producing a piezoelectric device, a piezoelectric device obtainable by that process, and a liquid droplet ejecting head using the same.

### BACKGROUND OF THE INVENTION

Conventionally known actuator is a piezoelectric device in which a piezoelectric film having such a piezoelectric effect that it is displaced in response to voltage application is combined with electrodes that apply voltage to the piezoelectric film. Examples of this piezoelectric device are described in JP 2005-101512 A, JP 5-235268 A, and JP 2000-299510 A and their piezoelectric films use a lead oxide such as lead zirconate titanate (also known as PZT).

JP 2005-101512 A describes a piezoelectric device comprising a piezoelectric film that consists of PZT to which niobium (Nb) has been added. By adding niobium, PbO loss is prevented and the occurrence of an unwanted phase near the interface between the piezoelectric film and an electrode is controlled to ensure that the piezoelectric device has an improved efficiency. JP 2005-101512 A states that Pb loss at site A is preferably held not more than 20%.

JP 5-235268 A describes a piezoelectric device that is produced by a process comprising the steps of forming a PZT precursor in which the concentration of Pb is held low in the region closer to a lower electrode and held high in the region closer to an upper electrode, and then annealing the PZT precursor to form a ferroelectric phase (corresponding to the piezoelectric film of the present invention). The piezoelectric device thus produced has a ferroelectric phase with satisfactory ferroelectric characteristics that is characterized by minimum variation of the Pb compositional ratio in the vertical direction. JP 5-235268 A also states that the PZT precursor having a distribution of the Pb concentration is prepared by a sputtering method or a sol-gel method.

JP 2000-299510 A describes a piezoelectric device using a piezoelectric film comprising PZT superposed on a common electrode, as well as an ink-jet head using the piezoelectric device. This document also states that a piezoelectric constant of PZT can be enhanced by setting its compositional ratio, Pb/(Zr+Ti), to be higher than 1 (specifically, not lower than 1.05) but not higher than 1.3. It also states that PZT is prepared by a sputtering method.

US 6,333,066 B1 discloses a method of forming a PZT thin film grown on a PbO seed layer or a PZT seed layer.

EP 0747976 A1 discloses a piezoelectric device comprising a three-component PZT film, the deviation of Pb content of the piezoelectric film in the thicknesswise direction thereof being within ±5%.

### SUMMARY OF THE INVENTION

As shown in JP 2005-101512 A and JP 5-235268 A, the method of forming a plurality of layers having different lead concentrations or the method of preparing a piezoelectric film that is loaded with niobium is capable of producing a piezoelectric device having high piezoelectric characteristics by making proper adjustment in anticipation of Pb loss or by preventing Pb loss that may occur during annealing, to thereby ensure that the resulting piezoelectric film has a uniform lead concentration. However, both methods involve an annealing treatment, so not only is unstable the lead concentration in the surface area of the piezoelectric film (the region closer to the upper electrode) but it is also impossible to enhance the piezoelectric characteristics and durability. Aside from this problem, the additional process makes it impossible to enhance the reproducibility of the device.

JP 2000-299510 A describes the preparation of PZT by sputtering. A problem with the production of a piezoelectric film by a vapor phase deposition such as a sputtering method is high likelihood for the formation of a pyrochlore phase. A piezoelectric film rich in the pyrochlore phase has such low piezoelectric characteristics and durability that its performance as a piezoelectric device is low. What is more, if a pyrochlore phase is present within perovskite, the piezoelectric characteristics of the resulting piezoelectric film vary with such factors as the position in which the pyrochlore phase is formed and its distribution in perovskite. Consequently, piezoelectric devices that use a piezoelectric film prepared by a sputtering method suffer scattering in performance and, hence, are low in reproducibility.

It is therefore an object of the present invention to solve the aforementioned problems of the prior art and provide a piezoelectric device having high piezoelectric characteristics and durability.

Another object of the present invention is to provide a liquid droplet ejecting head that uses the piezoelectric device having high piezoelectric characteristics and durability, to thereby ensure high performance in ejecting liquid droplets and a capability for recording image of high quality.

Yet another object of the present invention is to provide a process by which a piezoelectric device having high piezoelectric characteristics and durability can be produced with high reproducibility.

In order to achieve the above objects, according to a first aspect of the present invention, there is provided a process for producing a piezoelectric device as claimed in claim 1 of the present invention.

In order to achieve the above objects, according to a second aspect of the present invention, there is provided a piezoelectric device obtainable by the process of the first aspect of the invention and claimed in claim 5.

In order to achieve the above objects, according to a third aspect of the present invention, there is provided a liquid droplet ejecting head as claimed in claim 9.

According to the present invention, a piezoelectric film can be obtained that is free from Pb loss near the interface with the second electrode and which has a smaller content of a pyrochlore phase; the thus obtained piezoelectric film is enhanced in piezoelectric characteristics and durability.

The neighborhood of the interface with the second electrode is also adjusted to have the same composition as the other parts of the piezoelectric film to be obtained; as a result, Pb loss can be prevented from occurring in the neighborhood of the interface and there can be obtained a piezoelectric film that has as small a content of the pyrochlore phase in the neighborhood of the interface as in the other parts; this piezoelectric film is enhanced in piezoelectric characteristics and durability.

The proportion of the pyrochlore phase which is most likely to form near the interface is adjusted not to exceed a certain level, thereby producing a piezoelectric film having a smaller content of the pyrochlore phase. Reducing the content of the pyrochlore phase near the interface also contributes to reducing the leakage current that may flow between the piezoelectric film and the second electrode. This in turn contributes to enhancing the piezoelectric characteristics and durability of the piezoelectric film.

According to the present invention, not only the piezoelectric characteristics but also the durability of a piezoelectric device can be enhanced and this contributes to ensuring more positive ejection of liquid droplets, which in turn enables the provision of a liquid droplet ejecting head with enhanced durability.

The amount of Pb that contributes to the early stage of growth by a vapor phase deposition can be increased to thereby prevent the occurrence of Pb loss, as well as preventing or at least controlling the formation of a pyrochlore phase. This enables the production of a piezoelectric device that has a particularly small content of the pyrochlore phase near the interface, and as a result, piezoelectric devices having high piezoelectric characteristics and durability can be manufactured with high reproducibility.

### BRIEF DESCRIPTION OF THE DRAWINGS

FIG. 1 is a sectional view showing the general layout of an embodiment of an ink-jet head in an example of the liquid droplet ejecting head of the present invention that uses piezoelectric devices of the present invention.
FIG. 2 is a sectional view showing the general layout of an embodiment of an apparatus for producing a piezoelectric device that may be used in the process of the present invention for producing the piezoelectric device.

FIG. 3 is a flowchart depicting the steps in an example of the process of the present invention for producing a piezoelectric device.
FIG. 4 is a graph showing the results of measuring the orientation of the piezoelectric film as a component of the piezoelectric device of the present invention.
FIG. 5 is a graph showing the results of calculating the compositional profile at varying thicknesses of the piezoelectric film as a component of the piezoelectric device of the present invention.
FIG. 6 is a graph showing the results of measuring the orientation of the piezoelectric film prepared in a comparative example.
FIG. 7 is a graph showing the results of calculating the compositional profile at varying thicknesses of the comparative piezoelectric film.

### DETAILED DESCRIPTION OF THE INEVNTION

On the following pages, the piezoelectric device according to the present invention, the liquid droplet ejecting head that uses the same, and the process for producing the same are described in detail with reference to the embodiments depicted in the accompanying drawings.

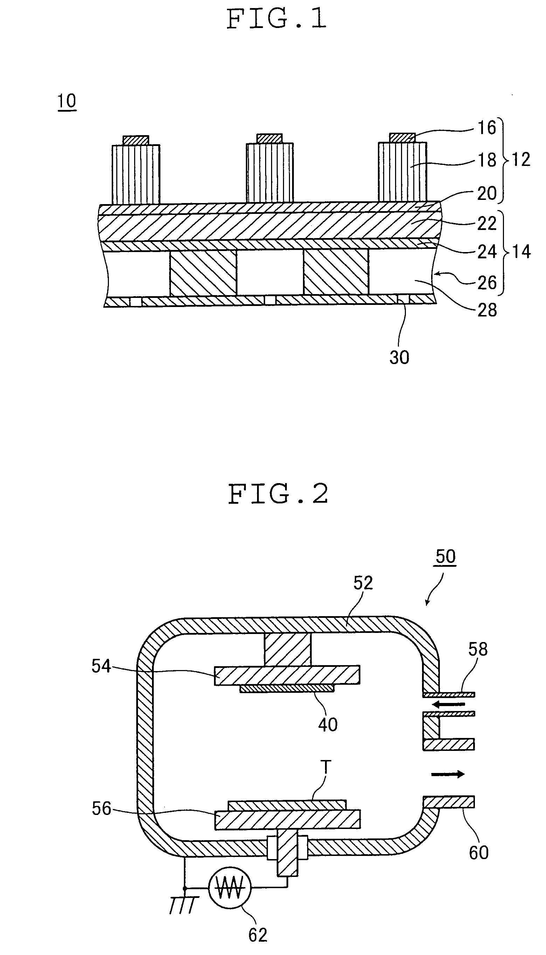

FIG. 1 is a sectional view showing the general layout of an embodiment of an ink-jet head which is an example of the liquid droplet ejecting head according to the second aspect of the present invention that uses piezoelectric devices according to the first aspect of the present invention.

An ink-jet head generally indicated by 10 in FIG. 1 comprises piezoelectric devices 12 and a substrate 14 that supports the piezoelectric devices 12.

As shown in FIG. 1, the ink-jet head 10 has a plurality of piezoelectric devices 12 arranged at given spacings on the substrate 14 such that one piezoelectric device 12 combines with the corresponding portion of the substrate 14 to form one ejecting portion. The respective ejecting portions have the same structure, so on the following pages, they are represented by one ejecting portion that is composed of one piezoelectric device 12 and the corresponding portion of the substrate 14, and the respective components are described below.

First, the piezoelectric device 12 comprises an upper electrode 16, a piezoelectric film 18, and a lower electrode 20; these components are superposed on the substrate 14 in the order of lower electrode 20, piezoelectric film 18, and upper electrode 16.

The upper electrode 16 is in a plate form and provided on one side of the piezoelectric film 18. The upper electrode 16 is connected to a power source not shown. This upper electrode 16 may be formed of various materials including, for example, metals such as Au, Pt and Ir, metal oxides such as IrO₂ RuO₂, LaNiO₃ and SrRuO₃, as well as electrode materials like Al, Ta, Cr and Cu that are commonly used in semiconductor processes, and combinations of these materials.

The lower electrode 20 is provided on the side of the piezoelectric film 18 which is away from the side where the upper electrode 16 is provided. In other words, the upper electrode 16 and the lower electrode 20 are provided in such a way that they sandwich the piezoelectric film 18. The lower electrode 20 is in a plate form that is common to the plurality of piezoelectric films 18. This lower electrode 20 is connected to a power source or a grounded terminal, neither of which is shown.

The lower electrode 20 may be formed of various materials including, for example, metals such as Au, Pt and Ir, metal oxides such as IrO₂, RuO₂, LaNiO₃ and SrRuO₃, and combinations of these materials.

The piezoelectric film 18 is a member that has a certain thickness in a direction from the upper electrode 16 toward the lower electrode 20 (from top to bottom as seen in FIG. 1) and it expands or contracts according as the applied voltage varies. The piezoelectric film 18 is mainly composed of Pb_{x/y}BO_{z/y} and formed on top of the lower electrode 20 by a vapor phase deposition, where B is an element at site B and selected from the group consisting of Ti, Zr, and Nb and where 1.2 ≤ x/y ≤ 1.6 and 2.5 ≤ z/y ≤ 3 are satisfied.

In a preferred embodiment, the piezoelectric film 18 has Zr and Ti as elements at site B. Being composed of PZT, the piezoelectric film 18 is capable of having enhanced piezoelectric characteristics and featuring a comparatively low price.

As already mentioned, piezoelectric films that are prepared from Pb_{x/y}BO_{z/y} by a vapor phase deposition have the disadvantages of low piezoelectric characteristics and durability.

As a result of their intensive studies made on this point, the present inventors have found that the piezoelectric characteristics and durability of a piezoelectric film are affected by its orientation and composition in the neighborhood of the interface with the lower electrode. More specifically, if Pb is deficient near the interface or if the content of the pyrochlore phase is high, the resulting piezoelectric film has a low piezoelectric constant as well as low durability.

The piezoelectric film 18 of the present invention satisfies the following conditions: the value of x/y in Pb_{x/y}BO_{z/y} in an area 100 nm apart from the surface of contact (i.e., interface) with the lower electrode 20 toward the upper electrode 16 should be 1.2 or more but no greater than 1.6; the value of x/y in Pb_{x/y}BO_{z/y} in an area 100 nm apart from the surface of contact with the lower electrode 20 toward the upper electrode 16 should be at least 1.1 times but no more than 1.5 times the value of x/y in Pb_{x/y}BO_{z/y} in the center area; and the ratio of perovskite peaks to pyrochlore peaks as measured by XRD (i.e., X-ray diffractometry) for an area 100 nm apart from the surface of contact with the lower electrode 20 toward the upper electrode 16 should be from 5.2 to 8.2.

The term "perovskite peaks" means the sum of all peaks attributable to the perovskite that have been detected by XRD measurement whereas "pyrochlore peaks" means the sum of all peaks attributable to the pyrochlore phase that have been detected by XRD measurement.

The "center area" means a site that is apart from the surface of contact between the lower electrode and the piezoelectric film toward the piezoelectric film (i.e., toward the upper electrode) by one half the thickness of the piezoelectric film.

By satisfying either one of the conditions set forth above, the piezoelectric film 18 can be enhanced in both piezoelectric characteristics, such as piezoelectric constant, and durability.

Specifically, by ensuring that the value of x/y in Pb_{x/y}BO_{z/y} in an area 100 nm apart from the surface of contact (i.e., interface) of the piezoelectric film 18 with the lower electrode 20 toward the upper electrode 16 is 1.2 or more, the lowering of a dielectric constant due to Pb loss near the interface can be prevented to secure a dielectric constant that is not lower than a certain value. By ensuring that x/y is not greater than 1.6, Pb near the interface can be prevented from becoming excessive so that Pb will not become metallic at the interface to thereby prevent an increase in the leakage current that flows between the piezoelectric film and the lower electrode. This contributes to an enhanced dielectric constant. Prevention of an increase in the leakage current flowing at the interface has an additional advantage; it contributes to preventing the occurrence of an excessive local load, so a piezoelectric device having an enhanced durability can be obtained.

By setting the value of x/y near the interface at 1.2 or more but no greater than 1.6 to thereby ensure that the proportion in quantity between Pb and the B site element takes a specified value, the content of the pyrochlore phase can be reduced but the amount of the crystalline perovskite structure increased.

In addition, by ensuring that the value of x/y in Pb_{x/y}BO_{z/y} in an area 100 nm apart from the surface of contact of the piezoelectric film 18 with the lower electrode 20 toward the upper electrode 16 is at least 1.1 times the value of x/y in Pb_{x/y}BO_{z/y} in the center area, Pb loss can be prevented from occurring near the interface to secure a dielectric constant that is not lower than a certain value. By ensuring that the value of x/y in an area 100 nm apart from the surface of contact with the lower electrode 20 toward the upper electrode 16 is not more than 1.5 times the value of x/y in the center area, Pb near the interface can be prevented from becoming excessive so that Pb will not become metallic at the interface.

Thus, by satisfying the aforementioned range of 1.1 to 1.5 times the value of x/y in Pb_{x/y}BO_{z/y} in the center area, the dielectric film can be provided with not only an enhanced dielectric constant but also increased durability.

Further in addition, by ensuring that the ratio of perovskite peaks to pyrochlore peaks as measured by XRD (i.e., X-ray diffractometry) for an area 100 nm apart from the surface of contact with the lower electrode 20 toward the upper electrode 16 is 5.2 or more to thereby reduce the content of the pyrochlore phase near the interface where it is highly likely to form, the content of the pyrochlore phase in the piezoelectric film can be reduced to provide it with a higher dielectric constant. What is more, by ensuring that perovskite occurs near the interface in a proportion higher than a specified value but reducing the amount of the pyrochlore phase containing a large number of fine cracks, the durability of the piezoelectric film can be enhanced. The increased proportion of perovskite also contributes to enhanced adhesion between the piezoelectric film and the lower electrode.

While the piezoelectric film 18 suffices to satisfy at least one of the aforementioned conditions, it preferably satisfies two of those three conditions, more preferably all of those three conditions.

In an even more preferred embodiment, the piezoelectric film 18 is such that the value of x/y in Pb_{x/y}BO_{z/y} in an area 100 nm apart from the surface of contact (i.e., interface) with the lower electrode 20 toward the upper electrode 16 is 1.2 or more but no greater than 1.4.

Since it is prepared by a vapor phase deposition, that part of the piezoelectric film 18 which extends from the neighborhood of the center area to the interface with the upper electrode has a uniform compositional profile with the value of x/y in Pb_{x/y}BO_{z/y} varying within ±2%.

Described above is the structure of the piezoelectric device 12.

To actuate this piezoelectric device 12, voltage is applied to the piezoelectric film 18 from the upper electrode 16 and the lower electrode 20 between which it is sandwiched. The piezoelectric film 18 expands or contracts according as voltage is applied from the upper electrode 16 and the lower electrode 20.

Described next is the substrate 14.

The substrate 14 comprises a support plate 22 that supports the piezoelectric device 12, a diaphragm 24 that transmits the vibrations of the piezoelectric device 12, and ink nozzles 26 that store ink and eject ink droplets in response to the vibrations of the diaphragm 24. The substrate 14 is such that the support plate 22, diaphragm 24, and ink nozzles 26 are superposed in that order as counted from the piezoelectric device 12.

The support plate 22 is a member in a plate form that is common to the plurality of piezoelectric devices 12, which are supported by this plate as it abuts against the lower electrode 20.

The support plate 22 may be a member in a plate form that is made from a variety of materials including silicon, glass, stainless steel, yttrium-stabilized zirconia (YSZ), alumina, sapphire, and silicon carbide. If desired, a laminated substrate such as an SOI substrate having a SiO₂ film and a Si active layer superposed in that order on a silicon substrate may be used as the support plate 22.

The diaphragm 24 is provided on that side of the support plate 22 which is away from the side where the piezoelectric devices 12 are provided. The diaphragm 24 vibrates as the piezoelectric devices 12 provided in positions away from it expand or contract.

The ink nozzles 26 are provided on that side of the diaphragm 24 which is away from the support plate 22 and are each formed of an ink compartment 28 for storing ink and an ink spout 30 through which ink droplets are ejected.

The ink compartment 28 is a space that stores a predetermined amount of ink and is provided in a position that faces a corresponding piezoelectric device 12. This ink compartment 28 is provided with one ink spout 30 on the side that is away from the piezoelectric device 12.

The ink compartment 28 is defined by the diaphragm 24 on the side that faces the piezoelectric device 12 and its capacity varies as the diaphragm 24 vibrates. To be more specific, when voltage is applied to the piezoelectric device 12, the diaphragm 24 vibrates and the decreasing capacity of the ink compartment 28 causes an ink droplet to emerge through the ink spout 30.

Note that the ink compartment 28 is connected to an ink supply means not shown so that once an ink droplet has been ejected through the ink spout 30, the ink compartment 28 is refilled with ink. This is how the ink compartment 28 keeps a specified amount of ink stored in it.

Described above is the basic structure of the ink-jet head 10.

We now explain how the ink-jet head 10 operates to eject ink.

It should first be mentioned that the lower electrode 20 in the ink-jet head 10 is common to the plurality of piezoelectric devices and is either supplied with a given voltage or grounded.

Given this condition, a voltage is applied to the upper electrode 16 in response to an image signal, whereupon the voltage on the piezoelectric film 18 varies to deform it.

When the piezoelectric film 18 deforms, the diaphragm 24 on one side of the ink compartment 28 that corresponds to the film 18 vibrates to reduce the capacity of the ink compartment 28.

When the capacity of the ink compartment 28 decreases, the pressure of the ink stored in the ink compartment 28 becomes high enough to eject an ink droplet through the ink spout 30.

Thus, in response to image signals, ink droplets are ejected to form an image or they are deposited on a medium of interest.

In the embodiment described above, the support plate 22, diaphragm 24, and ink nozzles 26 are formed as separate members; if desired, this may be replaced by a monolithic structure that consists of a single member in a plate form that is provided with not only ink compartments and ink nozzles but also a diaphragm.

In the foregoing embodiment, the liquid droplet ejecting head of the present invention has been described as an ink-jet head that ejects ink droplets but this is not the sole case of the present invention and it may be used as a variety of liquid droplet ejecting heads. For example, it may be used as a liquid droplet ejecting head by means of which an initiator of a chemical reaction is ejected as droplets onto a medium of interest or as a liquid droplet ejecting head by means of which a liquid is ejected as droplets into a solvent to mix in a specified amount.

We next describe the process for producing the piezoelectric device according to the present invention.

First, an exemplary apparatus that may be used to produce the piezoelectric device of the present invention is described.

FIG. 2 is a sectional view showing the general layout of an embodiment of a sputtering apparatus that may be used in the process for producing the piezoelectric device of the present invention.

The sputtering apparatus 50 is an apparatus that deposits a piezoelectric film 18 on the lower electrode 20 by a plasma-assisted sputtering method which is a vapor phase deposition; it comprises a vacuum vessel 52, a support section 54, a plasma electrode 56, a gas supply pipe 58, a gas exhaust pipe 60, and a RF power source 62.

The vacuum vessel 52 is a highly hermetic vessel that is formed of iron, stainless steel, aluminum or the like. The vacuum vessel 52 may be of various types that are employed in sputtering apparatuses, including a vacuum chamber, a bell jar, and a vacuum tank.

The support section 54 is provided within the vacuum vessel 52 on the side closer to the top. The support section 54 is composed of a support mechanism for supporting a base 40 having the lower electrode 20 formed on its lower side and a heating mechanism for heating the supported base 40 at a predetermined temperature.

The base 40 mentioned above is not limited in any particular way as long as it has the lower electrode 20 formed on its lower side; for example, it may be the support plate 22 having the lower electrode 20 formed on it, or it may be the substrate 14 provided with the support plate 22, diaphragm 24 and ink nozzles 26, or it may solely consist of the lower electrode 20, or it may be a member in a plate form that has the lower electrode 20 held temporarily on it.

The plasma electrode 56 is provided within the vacuum vessel 52 on the side closer to the bottom. Namely, the plasma electrode 56 is in a face-to-face relationship with the support section 54. The plasma electrode 56 has a target T mounting section on the side which faces the support section 54 and it is also connected to the RF power source 62 for applying voltage. The target T here referred to is a material that is suitably chosen in accordance with the composition of the film which is to be deposited on the lower electrode 20 in the base 40.

The gas supply pipe 58 is for supplying a gas or gases into the vacuum vessel 52 and is connected to a gas tank, a compressor or the like that are not shown. The gas exhaust pipe 60 is for discharging gases from within the vacuum vessel 52 and is connected to a compressor and the like that are not shown. Examples of the gas that may be introduced into the vacuum vessel 52 through the gas supply pipe 58 include argon (Ar) and a mixture of argon (Ar) and oxygen (O₂) gases.

We next describe the method of depositing a film with the sputtering apparatus 50.

First, the base 40 is mounted on the support section 54 and the target T on the mounting section of the plasma electrode 56. Then, the gas or gases in the vacuum vessel 52 are discharged through the gas exhaust pipe 60 while at the same time a gas is introduced into the vacuum vessel 52 through the gas supply pipe 58 until it is filled with the gas.

Subsequently, voltage is applied to the plasma electrode 56 from the RF power source 62 to cause discharge. When discharge occurs at the plasma electrode 56, the gas in the vacuum vessel 52 forms a plasma to generate positive ions of the gas. The generated positive ions sputter the target T. The constituent elements of the sputtered target T are released from the target and vapor-deposited, in either a neutral or ionized state, on the base 40.

This is how the sputtering apparatus 50 forms a film on the base 40.

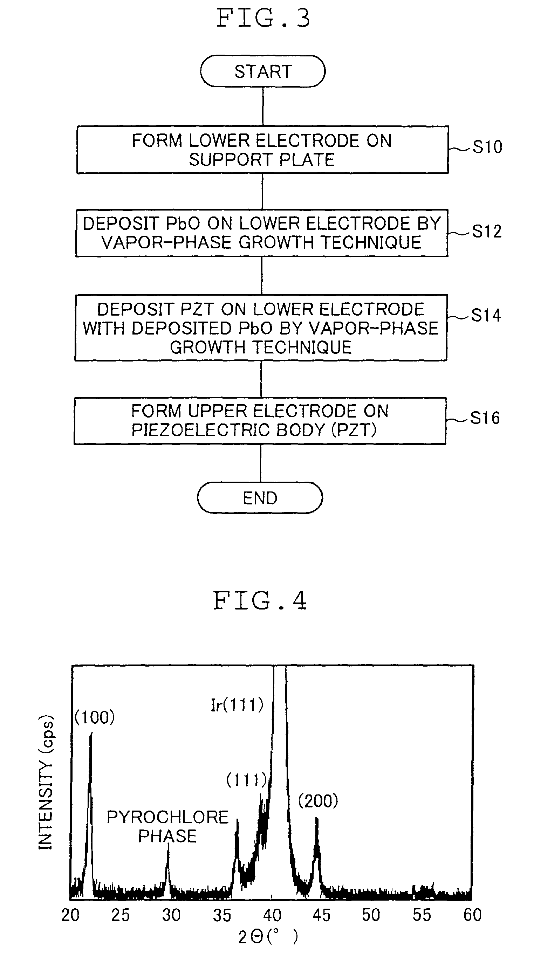

On the following pages, the process of the present invention for producing a piezoelectric device is described in greater detail with reference to FIG. 3. The following embodiment assumes the case of fabricating the piezoelectric device 12 on the support plate 22.

FIG. 3 is a flowchart illustrating the steps of producing the piezoelectric device.

First, the lower electrode 20 is formed on the support plate 22 (step S10). The lower electrode 20 may be fabricated by various methods including sputtering, evaporation, and mechanical attachment.

In the next step, a PbO film is deposited on the lower electrode 20 by a vapor phase deposition (step S12).

Specifically, the sputtering apparatus 50 is used and the support plate 22 having the lower electrode 20 formed thereon is set up as the base 40 whereas a PbO sinter is set up as the target T. Then, as mentioned above, the vacuum vessel 52 is filled with a predetermined gas and a plasma discharge is produced to form a PbO film on top of the lower electrode 20 in the base 40.

In the next step, PZT is deposited on the lower electrode 20 with the PbO film by a vapor phase deposition (step S14).

Specifically, the sputtering apparatus 50 is used again and the support plate 22 having the PbO film formed on the lower electrode 20 is set up as the base 40 whereas a PZT sinter is set up as the target T. Then, as mentioned above, the vacuum vessel 52 is filled with a predetermined gas and a plasma discharge is produced to deposit PZT on top of the lower electrode 20 in the base 40.

Note here that the PbO film has such a small thickness that it will be absorbed by PZT as the latter is deposited. In other words, once PZT has been deposited, it is only PZT that remains intact on top of the lower electrode 20. The PZT thusly formed on the lower electrode 20 serves as the piezoelectric film 18.

In the next step, the upper electrode 16 is formed on top of the piezoelectric film 18 (step S16). The upper electrode 16 may be fabricated by various methods including sputtering or evaporation that use a mask or the like, and mechanical attachment.

This is how the piezoelectric device is produced.

By forming the thin film of lead oxide (PbO) and the PZT film in that order as described above, more of Pb that is contributive in the initial stage of film deposition can be introduced to ensure there will be no Pb loss occurring near the interface of the piezoelectric film with the lower electrode. In addition, the proportions of Pb in the area near the interface of the piezoelectric film with the lower electrode and its center area can be adjusted to lie within a predetermined range. As a further advantage, the ratio of perovskite to the pyrochlore phase near the interface of the piezoelectric film with the lower electrode can be adjusted to be not smaleler than a certain value. In other words, one can fabricate a piezoelectric film having a small enough content of the pyrochlore phase.

By the above-described procedure, one can fabricate the piezoelectric device according to the present invention which has high piezoelectric characteristics and durability. In addition, the amount of the pyrochlore phase near the interface of the piezoelectric film with the lower electrode can be reduced and at the same time the loss of Pb can be reduced, whereby piezoelectric devices having high piezoelectric characteristics and durability can be produced with high reproducibility.

The thickness of the PbO film to be formed on the lower electrode is preferably adjusted to be 1 nm or more but not greater than 10 nm, more preferably 2 nm or more but not greater than 5 nm. By adjusting the thickness of the PbO film to be at least 1 nm, the proportion of Pb near the interface of the piezoelectric film with the lower electrode can be adjusted to be not smaller than a certain value and, what is more, the formation of the pyrochlore phase can be effectively prevented. By adjusting the thickness of the PbO film to be not greater than 10 nm, Pb can be prevented from becoming excessive and, hence, metallic in the neighborhood of the interface of the piezoelectric film with the lower electrode; as a further advantage, the adhesion between the piezoelectric film and the lower electrode can be sufficiently enhanced to prevent their separating from each other.

The above-described advantages can be attained more efficiently by adjusting the thickness of the PbO film to be 2 nm or more but not greater than 5 nm.

In the embodiment described above, the lower electrode is formed on the support plate 22 but this is not the sole case of the present invention and the step S10 as shown Fig. 3 may be omitted to form no lower electrode on the support plate. What is more, as mentioned in connection with the base 40 as shown Fig. 2, the lower electrode may be formed on a member in a plate form that is separate from the support plate or, alternatively, the lower electrode may be formed on a substrate provided with the support plate, the diaphragm, and the ink nozzles.

The foregoing embodiment relates to the case of fabricating a piezoelectric film by a plasma-assisted vapor phase deposition but this is not the sole case of the present invention and light-, heat- or otherwise assisted vapor phase deposition can also be employed; if one of various vapor phase deposition including sputtering, ion-beam sputtering, ion plating and CVD is employed to fabricate a piezoelectric film, the deposition of a PbO film may be followed by the deposition of PZT to thereby produce the piezoelectric device according to the first aspect of the present invention which has high piezoelectric characteristics and durability.

In the foregoing embodiment, the PbO film is formed on the lower electrode but it may be replaced by any kind of lead oxides such as lead dioxide or lead trioxide; in other words, the PbO film to be formed on the lower electrode may be represented by PbOₐ (a is any real number).

The foregoing embodiment assumes the case where a piezoelectric film is formed of PZT having Zr and Ti as elements at site B since it has high piezoelectric characteristics, is comparatively inexpensive and can be fabricated with ease; however, this is not the sole case of the present invention and even if a piezoelectric film that is based on the aforementioned Pb_{x/y}BO_{z/y} is to be fabricated, the formation of a PbOₐ film may be followed by the fabrication of Pb_{x/y}BO_{z/y} by a vapor phase deposition to achieve the above-mentioned beneficial features.

While the piezoelectric device according to the present invention, the liquid droplet ejecting head according to the invention which uses the piezoelectric device, and the process for producing the piezoelectric device according to the present invention have been described above in detail, it should be noted that the present invention is by no means limited to the embodiments described above and that various improvements and changes are possible without departing from the scope of the appended claims.

For example, the foregoing embodiments relate to the case where the piezoelectric device according to the present invention is used in the ink-jet head which is an embodiment of the liquid droplet ejecting head according to the present invention; however, this is not the sole case of the present invention and it may be applicable as a piezoelectric device for use in various applications including memories and pressure sensors.

### EXAMPLES

On the following pages, the piezoelectric device of the present invention and the process for producing it are described in greater detail with reference to specific examples.

### Example 1

The piezoelectric device used in Example 1 was fabricated by the following procedure.

An SOI substrate was used as the support. The lower electrode was formed on the SOI substrate by sputtering. More specifically, with the SOI substrate heated at 350 °C, Ti was evaporated to a thickness of 10 nm on the SOI substrate and Ir was then evaporated to a thickness of 300 nm to fabricate the lower electrode.

Subsequently, the SOI substrate with the lower electrode was set up within the sputtering apparatus 50 and a PbO sinter was also set up as the target. Thereafter, as it was degassed, the vacuum vessel was supplied with Ar gas to establish an Ar atmosphere having a total pressure of 0.3 Pa; the SOI substrate was further heated to 450 °C. Under these conditions, sputtering was performed to deposit PbO to a thickness of 10 nm on the lower electrode.

Then, the target was changed to Pb_{1.3}((Zr_{0.52}Ti_{0.48})_{0.9}Nb_{0.10})O₃ and a gaseous mixture of Ar/1%O₂ (consisting of Ar and O₂ gases mixed at a ratio of 100:1) was introduced to fill the vacuum vessel with that gaseous mixture. The plasma potential difference was set at 30 eV and the RF power was adjusted to 500 W. Under these conditions, sputtering was performed again to deposit PZT to a thickness of 4 µm on the lower electrode to fabricate a piezoelectric film.

The thus fabricated piezoelectric film was assembled in an open pool structure having a 1.1 mm opening and the piezoelectric constant d31 was measured. As it turned out, d31 was 250 pm/V.

The piezoelectric film was then polished to different thicknesses (as measured from the lower electrode) and the thus prepared samples were subjected to XRD measurement (i.e., X-ray diffractometry) and XRF measurement (i.e., X-ray fluorescence spectrometry). Based on the XRD measurement, the orientation of the piezoelectric film (i.e., PZT) was detected whereas on the basis of the XRF measurement, the composition of the piezoelectric film was detected for calculating the orientation and compositional profile of the piezoelectric film at the varying thicknesses.

The calculation showed that at the site where the film thickness was 4 µm, or on the surface of the piezoelectric film, it was completely composed of perovskite with (100) orientation.

The results of XRD measurement conducted at the site where the film thickness was 100 nm are shown in FIG. 4. The graph in FIG. 4 shows the results of XRD measurement conducted at the site where the film thickness was 100 nm; the vertical axis of the graph plots intensity [cps] and the horizontal axis plots 2Θ [°].

As FIG. 4 shows, the piezoelectric film at the site of 100 nm thickness was composed of perovskite with (100) orientation, perovskite with (111) orientation, perovskite with (200) orientation, and the pyrochlore phase. FIG. 4 also shows that Ir was detected in the lower electrode when an XRD measurement was conducted at the site of 100 nm thickness; however, this detection of Ir in the lower electrode can be disregarded as not reflecting the orientation of the piezoelectric film.

The ratio of perovskite peaks to pyrochlore peaks as calculated from the results of measurement shown in FIG. 4 was 6.3.

In the next place, the mass ratio of Pb/(Zr+Ti+Nb) was calculated from the compositional ratio as calculated from the results of XRF measurement. The calculations showed the following: Pb mass/(Zr+Ti+Nb) mass at the site of 4 µm thickness was 1.15; Pb mass/(Zr+Ti+Nb) mass at the site of 100 nm thickness was 1.20; and Pb mass/(Zr+Ti+Nb) mass at thicknesses of 2 µm to 4 µm were generally constant with variations lying within 2%.

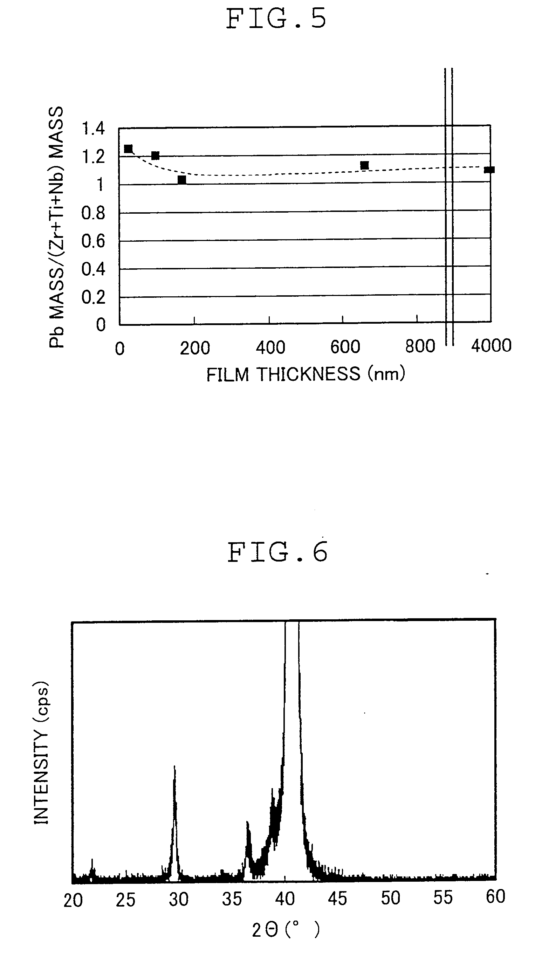

The results of calculation are shown in FIG. 5, which is a graph showing the relation between film thickness and Pb mass/(Zr+Ti+Nb) mass; the vertical axis of the graph plots Pb mass/(Zr+Ti+Nb) mass and the horizontal axis plots film thickness [nm].

As FIG. 5 shows, the piezoelectric film had a high proportion of Pb even in the neighborhood of the interface with the lower electrode. The ratio of Pb mass/(Zr+Ti+Nb) mass at the site of 100 nm thickness (which is hereinafter sometimes referred to as point A) to Pb mass/(Zr+Ti+Nb) mass in the center area of the piezoelectric film, or at the site of 2 µm thickness (which is hereinafter sometimes referred to as point B), namely, the ratio of Pb mass/(Zr+Ti+Nb) mass at point A to Pb mass/(Zr+Ti+Nb) mass at point B (the site of 2000 nm thickness) was 1.1 (this ratio is hereinafter simply referred to as "point A/point B".

### Examples 2 to 5

The film deposition conditions of Example 1 were changed in such a way that Pb mass/(Zr+Ti+Nb) mass at the site of 100 nm thickness would be 0.8 (Example 2), 1.0 (Example 3), 1.4 (Example 4) and 1.6 (Example 5). The thus fabricated piezoelectric devices were subjected to the same measurements and calculations as in Example 1.

The results of the measurements and calculations were as follows. In Example 2 which is outside the scope of the present invention, the piezoelectric constant d31 was 240 pm/V, the ratio of perovskite peaks to pyrochlore peaks at 100 nm thickness was 0.2, and point A/point B was 0.7.

In Example 3 which is outside the scope of the present invention, the piezoelectric constant d31 was 250 pm/V, the ratio of perovskite peaks to pyrochlore peaks at 100 nm thickness was 1.0, and point A/point B was 0.9.

In Example 4, the piezoelectric constant d31 was 250 pm/V, the ratio of perovskite peaks to pyrochlore peaks at 100 nm thickness was 8.2, and point A/point B was 1.3.

In Example 5, the piezoelectric constant d31 was 240 pm/V, the ratio of perovskite peaks to pyrochlore peaks at 100 nm thickness was 5.2, and point A/point B was 1.5.

### Comparative Example 1

In Comparative Example 1, a piezoelectric device was fabricated by the following procedure.

An SOI substrate was used as the support. The lower electrode was formed on the SOI substrate by sputtering. More specifically, with the SOI substrate heated at 350 °C, Ti was evaporated to a thickness of 10 nm on the SOI substrate and Ir was then evaporated to a thickness of 300 nm to fabricate the lower electrode.

Subsequently, the SOI substrate with the lower electrode was set up within the sputtering apparatus 50 and Pb_{1.3}((Zr_{0.52}Ti_{0.48})_{0.9}Nb_{0.10})O₃ was also set up as the target. Thereafter, as it was degassed, the vacuum vessel was supplied with a gaseous mixture of Ar/1%O₂ to establish a mixed gas atmosphere having a total pressure of 0.3 Pa; the SOI substrate was further heated to 450 °C. The plasma potential difference was set at 30 eV and the RF power was adjusted to 500 W. Under these conditions, sputtering was performed again to deposit PZT to a thickness of 4 µm on the lower electrode to fabricate a piezoelectric film.

As in Examples 1-5, the thus fabricated piezoelectric film was assembled in an open pool structure having a 1.1 mm opening and the piezoelectric constant d31 was measured. As it turned out, d31 was 100 pm/V.

As in Examples 1 to 5, the piezoelectric film was subjected to XRD measurement and XRF measurement at varying film thicknesses for calculating the orientation and compositional profile of the film at those thicknesses.

The calculation showed that at the site where the film thickness was 4 µm, or on the surface of the piezoelectric film, the sample of Comparative Example 1 was also completely composed of perovskite with (100) orientation.

The results of XRD measurement conducted at the site of 100 nm thickness are shown in FIG. 6. The graph in FIG. 6 shows the results of XRD measurement conducted at the site of 100 nm thickness; the vertical axis of the graph plots intensity [cps] and the horizontal axis plots 20 [°].

As FIG. 6 shows, the piezoelectric film at the site of 100 nm thickness contained more of the pyrochlore phase but less of perovskite. In Comparative Example 1, too, Ir was detected in the lower electrode but this can be disregarded as not reflecting the orientation of the piezoelectric film.

The ratio of perovskite peaks to pyrochlore peaks as calculated from the results of measurement shown in FIG. 6 was 0.2.

Further, the mass ratio of Pb/(Zr+Ti+Nb) was calculated for each of the film thicknesses from the results of measurement of the compositional ratio. The calculations showed Pb mass/(Zr+Ti+Nb) mass at the site of 4 µm thickness was 1.1 and Pb mass/(Zr+Ti+Nb) mass at the site of 100 nm thickness was 0.6. In Comparative Example 1, too, Pb mass/(Zr+Ti+Nb) mass at thicknesses of 2 µm to 4 µm was generally constant with variations lying within 2%.

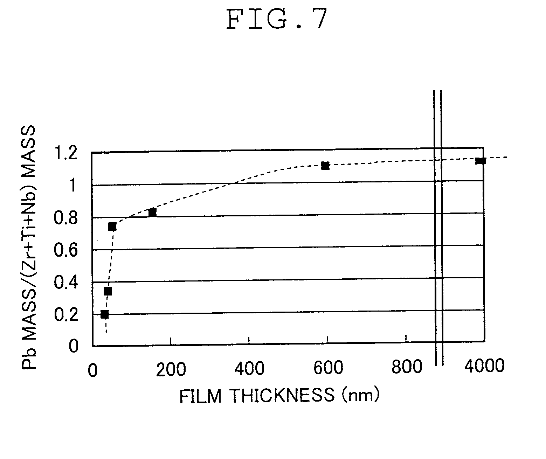

The results of calculation are shown in FIG. 7, which is a graph showing the relation between film thickness and Pb mass/(Zr+Ti+Nb) mass; the vertical axis of the graph plots Pb mass/(Zr+Ti+Nb) mass and the horizontal axis plots film thickness [nm].

As FIG. 7 shows, the piezoelectric film of Comparative Example 1 had Pb loss occurring in the lower surface in contact with the lower electrode, which resulted in a smaller content of Pb in that area.

The value of point A/point B was 0.5.

### Comparative Example 2

In Comparative Example 2, a piezoelectric device was fabricated by the following procedure.

An SOI substrate was used as the support. The lower electrode was formed on the SOI substrate by sputtering. More specifically, with the SOI substrate heated at 350 °C, Ti was evaporated to a thickness of 10 nm on the SOI substrate and Ir was then evaporated to a thickness of 300 nm to fabricate the lower electrode.

Then, PbO was deposited to a thickness of 15 nm on the lower electrode by sputtering under the same conditions as in the already described Example 1.

Subsequently, the SOI substrate with the lower electrode was set up within the sputtering apparatus 50 and Pb_{1.3}((Zr_{0.52}Ti_{0.48})_{0.9}Nb_{0.10})O₃ was also set up as the target. Thereafter, as it was degassed, the vacuum vessel was supplied with a gaseous mixture of Ar/1%O₂ to establish a mixed gas atmosphere having a total pressure of 0.3 Pa; the SOI substrate was further heated to 450 °C. The plasma potential difference was set at 30 eV and the RF power was adjusted to 500 W. Under these conditions, sputtering was performed again to deposit PZT to a thickness of 4 µm on the lower electrode with the PbO layer to fabricate a piezoelectric film.

As in Examples 1-5, the thus fabricated piezoelectric film was assembled in an open pool structure having a 1.1 mm opening and the piezoelectric constant d31 was measured. As it turned out, d31 was 130 pm/V. The piezoelectric film was so low in adhesion that partial separation of layers had occurred.

As in Examples 1 to 5 and Comparative Example 1, the piezoelectric film was subjected to XRD measurement and XRF measurement at varying film thicknesses for calculating the orientation and compositional profile of the film at those thicknesses.

The calculations showed that Pb mass/(Zr+Ti+Nb) mass at the site of 4 µm thickness was 1.1 and Pb mass/(Zr+Ti+Nb) mass at the site of 100 nm thickness was 2.0. Thus, the piezoelectric film of Comparative Example 2 obviously had an excessive amount of Pb present near the interface with the lower electrode.

The ratio of perovskite peaks to pyrochlore peaks at the film thickness of 100 nm was 0.1 and the value of point A/point B was 1.8.

The results of measurements conducted in the foregoing Examples and Comparative Examples are summarized in Table 1 below.

**Table 1**

| | Pb mass/ (Zr+Ti+Nb) mass | Perovskite/ pyrochlore ratio | Point A/ point B | Piezoelectric constant d31(pm/V) | Rating |
|---|---|---|---|---|---|
| EX 2 | 0.8 | 0.2 | 0.7 | 240 | Good |
| EX 3 | 1.0 | 1.0 | 0.9 | 250 | Good |
| EX 1 | 1.2 | 6.3 | 1.1 | 250 | Good |
| EX 4 | 1.4 | 8.2 | 1.3 | 250 | Good |
| EX 5 | 1.6 | 5.2 | 1.5 | 240 | Good |
| CE 1 | 0.6 | 0.05 | 0.5 | 100 | Poor |
| CE 2 | 2.0 | 0.1 | 1.8 | 130 | Poor |

As is clear from Examples 1 to 5 and Comparative Examples 1 and 2, the dielectric constant d31 can be enhanced by adjusting Pb mass/(Zr+Ti+Nb) mass, or x/y in Pb_{x/y}BO_{z/y}, to 1.2 or more but not greater than 1.6.

The dielectric constant d31 can also be enhanced by adjusting the value of point A/point B to 1.1 or more but not greater than 1.5.

The same result can be obtained by adjusting the ratio of perovskite peaks to pyrochlore peaks from 5.2 to 8.2.

It can also be seen that the piezoelectric films of Examples 1 to 5 that were fabricated by forming the PZT layer after the PbO layer had higher values of the piezoelectric constant d31 than the piezoelectric film of Comparative Example 1 that was fabricated by direct deposition of PZT.

It is also clear from Examples 1 to 5 and Comparative Example 2 that by adjusting the thickness of the PbO layer to 1 nm or more but not greater than 10 nm, piezoelectric films having higher values of d31 could be formed, with the additional advantage of exhibiting enhanced adhesion to the lower electrode.

Fabricating piezoelectric films by forming the PZT layer after the PbO layer offers the added advantage that even when vapor phase deposition was applied, Pb loss could be prevented from occurring near the interface with the lower electrode, thus ensuring that certain amounts of Pb would be retained not only in the center area but also near the interface.

As a further advantage, there could be fabricated such piezoelectric films that the content of the pyrochlore phase at the site of 100 nm thickness, namely, in the neighborhood of the interface was smaller and that the relative proportions of Pb near the interface and Pb in the center area were within the specified range.

The foregoing clearly shows the benefits of the present invention.

## Claims

1. A process for producing a piezoelectric device (12) comprising a first electrode (16), a piezoelectric film (18) and a second electrode (20) that are provided in a superposed relationship, the process comprising the steps of:
depositing a PbO film on a surface of said second electrode (20) by a vapor phase deposition,
wherein said PbO film deposited on the surface of said second electrode (20) has a thickness of 1 nm or more but not greater than 10 nm; and
depositing a perovskite-type piezoelectric film (18) on a surface of said PbO film by a vapor phase deposition, the composition of said piezoelectric film (18) being expressed as Pb_{x/y}BO_{z/y} where B represents one or more elements selected from the group consisting of Ti, Zr, and Nb, and where 1.2 ≤ x/y ≤ 1.6 and 2.5 < z/y ≤ 3 are satisfied, and
further wherein said piezoelectric film (18) has a first value of x/y ranging from 1.2 to 1.6 in an area of the piezoelectric film (18) 100 nm apart from a surface of contact with the second electrode (20) toward the first electrode (16),
said first value of x/y in said area of said piezoelectric film (18) 100 nm apart from the surface of contact with said second electrode (20) toward said first electrode (16) is 1.1 times or more but not greater than 1.5 times a second value of x/y in a center area of said piezoelectric film (18), and
said area of said piezoelectric film (18) 100 nm apart from the surface of contact with said second electrode (20) toward said first electrode (16) has a ratio of perovskite peaks to pyrochlore peaks as measured by XRD of from 5.2 to 8.2.

2. The process for producing the piezoelectric device (12) according to claim 1, wherein a part of said piezoelectric film (18) which extends from the center area to an interface with said first electrode (16) has a uniform compositional profile with a third value of x/y varying within ±2%.

3. The process for producing the piezoelectric device (12) according to claim 1 or 2, wherein the piezoelectric film (18) is formed on the second electrode (20) by a plasma-assisted sputtering method as said vapor phase deposition.

4. The process for producing the piezoelectric device (12) according to any one of claims 1 to 3, wherein said element at site B in Pb_{x/y}BO_{z/y} contains at least Zr and Ti.

5. A piezoelectric device (12) comprising:
a piezoelectric film (18) that expands or contracts according to variations in voltage applied;
a first electrode (16) for applying the voltage to the piezoelectric film (18), provided on a first side of the piezoelectric film; and
a second electrode (20) for applying the voltage to the piezoelectric film (18), provided on a second side of the piezoelectric film which is away from the first side where the first electrode (16) is provided,
**characterized in that** the piezoelectric film (18) is obtainable by the process claimed in any one of claims 1 to 4.

6. The piezoelectric device (12) according to claim 5, wherein a part of said piezoelectric film (18) which extends from the center area to an interface with said first electrode (16) has a uniform compositional profile with a third value of x/y varying within ±2%.

7. The piezoelectric device (12) according to claim 5 or 6, wherein the piezoelectric film (18) is formed on the second electrode (20) by a plasma-assisted sputtering method as said vapor phase deposition.

8. The piezoelectric device (12) according to any one of claims 5 to 7, wherein said element at site B in Pb_{x/y}BO_{z/y} contains at least Zr and Ti.

9. A liquid droplet ejecting head comprising:
a piezoelectric device (12), and
a substrate (14) for supporting said piezoelectric device (12), the substrate (14) having a liquid compartment (28) in an area of contact with said piezoelectric device (12) that varies in capacity in response to deformation of said piezoelectric device (12) and which has a spout (30) as an opening through which liquid droplets are ejected,
**characterized in that** the device (12) is a device according to any one of claims 5 to 8.

## Patentansprüche

1. Verfahren zur Herstellung einer piezoelektrischen Vorrichtung (12) aufweisend eine erste Elektrode (16), einen piezoelektrischen Film (18) und eine zweite Elektrode (20), die in einer übereinanderliegenden Beziehung vorgesehen sind, wobei das Verfahren folgende Schritte aufweist:
Abscheiden eines PbO-Films auf einer Oberfläche der zweiten Elektrode (20) mittels einer Dampfphasenabscheidung,
wobei der auf der Oberfläche der zweiten Elektrode (20) abgeschiedene PbO-Film eine Dicke von 1 nm oder mehr, aber nicht größer als 10 nm hat; und
Abscheiden eines piezoelektrischen Films (18) vom Perowskit-Typ auf einer Oberfläche des PbO-Films mittels einer Dampfphasenabscheidung, wobei die Zusammensetzung des piezoelektrischen Films (18) ausgedrückt wird als Pb_{x/y}BO_{z/y,} wobei B ein oder mehrere Elemente repräsentiert, die ausgewählt werden aus der Gruppe, die aus Ti, Zr und Nb besteht, und wobei 1,2 ≤ x/y ≤ 1,6 und 2,5 < z/y ≤ 3 erfüllt sind, und
wobei außerdem der piezoelektrische Film (18) einen ersten Wert von x/y, der im Bereich von 1,2 bis 1,6 liegt, in einem Bereich des piezoelektrischen Films (18) 100 nm entfernt von einer Kontaktoberfläche mit der zweiten Elektrode (20) in Richtung der ersten Elektrode (16) hat,
der erste Wert von x/y in dem Bereich des piezoelektrischen Films (18) 100 nm entfernt von der Kontaktoberfläche mit der zweiten Elektrode (20) in Richtung der ersten Elektrode (16) das 1,1-fache oder mehr, aber nicht größer als das 1,5-fache eines zweiten Werts von x/y in einem mittigen Bereich des piezoelektrischen Films (18) ist, und
der Bereich des piezoelektrischen Films (18) 100 nm entfernt von der Kontaktoberfläche mit der zweiten Elektrode (20) in Richtung der ersten Elektrode (16) ein Verhältnis von Perowskit-Peaks zu Pyrochlor-Peaks von 5,2 bis 8,2, wie gemessen durch Röntgendiffraktometrie, hat.

2. Verfahren zur Herstellung der piezoelektrischen Vorrichtung (12) nach Anspruch 1, wobei ein Teil des piezoelektrischen Films (18), der sich von dem mittigen Bereich zu einer Grenzfläche mit der ersten Elektrode (16) erstreckt, ein gleichmäßiges Zusammensetzungsprofil mit einem dritten Wert von x/y, der innerhalb von ± 2 % variiert, hat.

3. Verfahren zur Herstellung der piezoelektrischen Vorrichtung (12) nach Anspruch 1 oder 2, wobei der piezoelektrische Film (18) auf der zweiten Elektrode (20) mittels eines plasmagestützten Sputterverfahrens als die Dampfphasenabscheidung ausgebildet wird.

4. Verfahren zur Herstellung der piezoelektrischen Vorrichtung (12) nach einem der Ansprüche 1 bis 3, wobei das Element an der Stelle B in Pb_{x/y}BO_{z/y} mindestens Zr und Ti enthält.

5. Piezoelektrische Vorrichtung (12) aufweisend:
einen piezoelektrischen Film (18), der sich entsprechend Schwankungen der angelegten Spannung ausdehnt oder zusammenzieht;
eine erste Elektrode (16) zum Anlegen der Spannung an den piezoelektrischen Film (18), die an einer ersten Seite des piezoelektrischen Films vorgesehen ist; und
eine zweite Elektrode (20) zum Anlegen der Spannung an den piezoelektrischen Film (18), die an einer zweiten Seite des piezoelektrischen Films vorgesehen ist, die entfernt ist von der ersten Seite, an der die erste Elektrode (16) vorgesehen ist,
**dadurch gekennzeichnet, dass** der piezoelektrische Film (18) nach dem in einem der Ansprüche 1 bis 4 beanspruchten Verfahren erhältlich ist.

6. Piezoelektrische Vorrichtung (12) nach Anspruch 5, bei der ein Teil des des piezoelektrischen Films (18), der sich von dem mittigen Bereich zu einer Grenzfläche mit der ersten Elektrode (16) erstreckt, ein gleichmäßiges Zusammensetzungsprofil mit einem dritten Wert von x/y, der innerhalb von ± 2 % variiert, hat.

7. Piezoelektrische Vorrichtung (12) nach Anspruch 5 oder 6, bei der der piezoelektrischen Film (18) auf der zweiten Elektrode (20) mittels eines plasmagestützten Sputterverfahrens als die Dampfphasenabscheidung ausgebildet wird.

8. Piezoelektrische Vorrichtung (12) nach einem der Ansprüche 5 bis 7, bei der das Element an der Stelle B in Pb_{x/y}BO_{z/y} mindestens Zr und Ti enthält.

9. Flüssigkeitstropfen-Ausstoßkopf aufweisend:
eine piezoelektrische Vorrichtung (12) und
ein Substrat (14) zum Tragen der piezoelektrischen Vorrichtung (12), wobei das Substrat (14) eine Flüssigkeitskammer (28) in einem Kontaktbereich mit der piezoelektrischen Vorrichtung (12) hat, deren Fassungsvermögen als Reaktion auf eine Verformung der piezoelektrischen Vorrichtung (12) variiert, und die eine Mündung (30) als eine Öffnung hat, durch die Flüssigkeitstropfen ausgestoßen werden,
**dadurch gekennzeichnet, dass** die Vorrichtung (12) eine Vorrichtung nach einem der Ansprüche 5 bis 8 ist.

## Revendications

1. Procédé destiné à produire un dispositif piézoélectrique (12) comprenant une première électrode (16), un film piézoélectrique (18), et une seconde électrode (20) fournis suivant une relation de superposition, le procédé comprenant les étapes consistant à :
déposer un film de PbO sur une surface de ladite seconde électrode (20) par un dépôt en phase vapeur,
dans lequel ledit film PbO déposé sur la surface de ladite seconde électrode (20) présente une épaisseur de 1 nm ou plus, mais inférieure à 10 nm, et
déposer un film piézoélectrique de type pérovskite (18) sur une surface dudit film de PbO par un dépôt en phase vapeur, la composition dudit film piézoélectrique (18) étant exprimée sous la forme Pb_{x/y}BO_{z/y}, où B représente un ou plusieurs éléments sélectionnés parmi le groupe consistant en Ti, Zr et Nb, et où 1,2≤x/y≤1,6, et 2,5<z/y≤3 sont satisfaites, et
dans lequel en outre, ledit film piézoélectrique (18) présente une première valeur de x/y comprise dans l'intervalle allant de 1,2 à 1,6 dans une zone du film piézoélectrique (18) éloignée de 100 nm d'une surface de contact avec la seconde électrode (20) vers la première électrode (16),
ladite première valeur de x/y dans ladite zone dudit film piézoélectrique (18) éloignée de 100 nm de la surface de contact avec la seconde électrode (20) vers ladite première électrode (16) est égale ou supérieure à 1,1 fois, mais n'est pas supérieure à 1,5 fois, une deuxième valeur de x/y dans une zone centrale dudit film piézoélectrique (18), et
ladite zone dudit film piézoélectrique (18) éloignée de 100 nm de la surface de contact avec ladite seconde électrode (20) vers ladite première électrode (16) présente un rapport des crêtes de pérovskite à des crêtes de pyrochlore comme mesuré par XRD allant de 5,2 à 8,2.

2. Procédé destiné à produire un dispositif piézoélectrique (12) selon la revendication 1, dans lequel une partie dudit film piézoélectrique (18), qui s'étend de la zone centrale à une interface avec ladite première électrode (16), présente un profil de composition uniforme avec une troisième valeur de x/y variant dans les limites de ±2 %.

3. Procédé destiné à produire un dispositif piézoélectrique (12) selon la revendication 1 ou 2, dans lequel le film piézoélectrique (18) est formé sur la seconde électrode (20) par un procédé de pulvérisation assisté par plasma comme ledit dépôt en phase vapeur.

4. Procédé destiné à produire un dispositif piézoélectrique (12) selon l'une quelconque des revendications 1 à 3, dans lequel ledit élément au site B dans Pb_{x/y}BO_{z/y} contient au moins du Zr et Ti.

5. Dispositif piézoélectrique (12), comprenant :
un film piézoélectrique (18) qui se dilate ou se contracte en fonction de variations de la tension appliquée ;
une première électrode (16) destinée à appliquer la tension au film piézoélectrique (18), fournie sur un premier côté du film piézoélectrique, et
une seconde électrode (20) destinée à appliquer la tension au film piézoélectrique (18), fournie sur un second côté du film piézoélectrique qui est éloigné du premier côté où la première électrode (16) est fournie,
**caractérisé en ce que** le film piézoélectrique (18) peut être obtenu par le procédé selon l'une quelconque des revendications 1 à 4.

6. Dispositif piézoélectrique (12) selon la revendication 5, dans lequel une partie dudit film piézoélectrique (18), qui s'étend de la zone centrale à une interface avec ladite première électrode (16), présente un profil de composition uniforme avec une troisième valeur de x/y variant dans des limites de ±2 %.

7. Dispositif piézoélectrique (12) selon la revendication 5 ou 6, dans lequel le film piézoélectrique (18) est formé sur la seconde électrode (20) par un procédé de pulvérisation assisté par plasma comme ledit dépôt en phase vapeur.

8. Dispositif piézoélectrique (12) selon l'une quelconque des revendications 5 à 7, dans lequel ledit élément au site B dans Pb_{x/y}BO_{z/y} contient au moins du Zr et Ti.

9. Tête d'éjection de gouttelettes liquides, comprenant :
un dispositif piézoélectrique (12), et
un substrat (14) destiné à supporter ledit dispositif piézoélectrique (12), le substrat (14) présentant un compartiment de liquide (28) dans une zone de contact avec ledit dispositif piézoélectrique (12) dont la capacité varie en réaction à une déformation dudit dispositif piézoélectrique (12) et qui présente un bec (30) comme ouverture à travers laquelle des gouttelettes liquides sont éjectées,
**caractérisé en ce que** le dispositif (12) est un dispositif selon l'une quelconque des revendications 5 à 8.
